# EUROPÄISCHE PATENTANMELDUNG

(11) **EP 1 093 224 A2**
(43) Veröffentlichungstag der Anmeldung: **18.04.2001**
(21) Anmeldenummer: 00118383.9
(22) Anmeldetag: 24.08.2000
(51) Int. Cl.: H03K 5/1536, H03K 5/08

(54) **Impulsdetektor und Verfahren zur Detektion von sinusförmigen Impulsen**

(30) Priorität: 11.10.1999 DE 19948892
(71) Anmelder: ASM AUTOMATION, SENSORIK, MESSTECHNIK GMBH, D-85452 Moosinning (DE)
(72) Erfinder: Wirth, Peter, 85386 Eching (DE); Steinich, Klaus-Manfred, 85604 Poering (DE)
(74) Vertreter: Strych, Werner Maximilian Josef, Dr.

(57) **Zusammenfassung**

Die Erfindung betrifft ein ein Verfahren und eine Vorrichtung zu Detektion von sinusförmigen Impulsen. Der Impulsdetektor umfaßt einen Komparator (31), dessen einer Eingang mit dem elektrischen Impulssignal gespeist wird und dessen anderer Eingang an einer vorgegebenen Referenzspannung (U_{ref1}) liegt, die auf einen nullpunktnahen Wert eingestellt ist, und eine Logikeinheit (35), die mit dem Ausgang des Komparators (31) verbunden ist. Der erfindungsgemäße Impulsdetektor ist gegenüber veränderlichen Amplituden der zu erfassenden Impulse besonders invariant und weist eine hohe Störsicherheit auf. Dies wird dadurch erreicht, daß die Logikeinheit (35) das Ausgangssignal des Komparators (31) mit einer vorgegebenen Abtastfrequenz abtastet und erst dann ein internes Aktivierungssignal erzeugt, wenn mehrere gültige Abtastwerte vorliegen, so daß bei Unterschreiten des Impulssignals (P) unter die nullpunktnahe Referenzspannung (U_{ref1}) und Vorliegen eines Aktivierungssignals ein Impulsdetektorausgangssignal (STOP) erzeugt wird.

## Beschreibung

Die Erfindung betrifft die Detektion gedämpfter Sinuswellen, und insbesondere die Detektion von mechanisch elastischen Positionsimpulsen auf dem Wellenleiter eines magnetostriktiven Positionssensors.

In einem magnetostriktiven Positionssensor werden durch Erregung elektrischer Stromimpulse magnetoelastische Positionsimpulse erzeugt, die sich entlang eines ferromagnetischen Wellenleiters ausbreiten. Ein externer Magnet, der als Positionsmarkierung dient, ist entlang des magnetostriktiven Wellenleiters verschiebbar angeordnet. Nach dem Auslösen eines Erregerstromimpulses tritt das magnetische Feld des externen Magneten mit dem elektromagnetischen Feld, das durch den Stromimpuls erzeugt wird, in Wechselwirkung. An dem Ort der Wechselwirkung wird ein Torsionsmoment auf den Weltenleiter ausgeübt, das einen mechanisch elastischen Torsionsimpuls hervorruft, der sich entlang des Wellenleiters ausbreitet. Dieser mechanisch elastische Positionsimpuls wird von einem Impulsdetektor erfaßt und ausgewertet. Das Zeitintervall zwischen der Erregung des Stromimpulses und dem Empfangen des magnetoelastischen Positionsimpulses an einem Ende des Wellenleiters ist ein Maß für den Abstand des verschiebbaren Positionsmagneten von diesem Ort.

Bei der Auswertung des vom Impulsaufnehmer ausgegebenen Spannungsimpulses ist zu berücksichtigen, daß die Amplitude des Spannungsimpulses von verschiedenen Einflußgrößen abhängig ist. So können z. B. Fertigungstoleranzen in der Feldstärke des Positionsmagneten oder beim Impulsdetektor, Änderungen des Abstands des Positionsmagneten zum Wellenleiter und nicht zuletzt Temperatureinflüsse die Meßgröße und deren Auswertung stark beeinträchtigen. Insbesondere die magnetostriktiven Konstanten des magnetischen Materials des Wellenleiters und des Modemwandlers sind temperaturabhängig, wodurch Unterschiede bei den Impulsamplituden entstehen. Auch mit zunehmender Entfernung von dem Ort der Entstehung schwächt sich die Amplitudenhöhe ab. Es ist außerdem zu berücksichtigen, daß bei industriellen Anwendungen Störimpulse aus verschiedenen Quellen sich teilweise mit dem Positionssignal überlagern und von diesem unterschieden werden müssen.

Das US-Patent Nr. 5,212,444 beschreibt einen Impulsdetektor zur Erfassung von Sinuswellen auf einem magnetostriktiven Wellenleiter eines Positionssensors. Der Impulsdetektor umfaßt einen ersten Komparator mit einem negativen Schaltpunkt zur Amplitudenerkennung der negativen Halbwelle eines Positionsimpulses, einen zweiten Komparator mit einem Schaltpunkt entgegengesetzter Polarität zur Erkennung des Nulldurchgangs der Hauptwelle des Positionssignals, zwei D-Flip-Flops, zwei Zeitstufen und logische Verknüpfungselemente. Bei Unterschreiten der Amplitude des Positionssignals unter die zweite nullpunktnahe Referenzspannung wird am Ausgang des Impulsdetektors ein Ausgangssignal erzeugt. Der Impulsdetektor hat jedoch den Nachteil, daß das Ausgangssignal der Komparatoren flankenabhängig (d.h. unmittelbar bei Über- bzw. Unterschreiten des Schwellenwertes) ausgewertet wird. Solche flankengetriggerten Auswertungen von Logiksignalen sind jedoch immer empfindlich gegen Störimpulse. Darüber hinaus benötigt der beschriebene Impulsdetektor eine bipolare Spannungsversorgung für die signalverarbeitenden Bauelemente, wie z. B. Komparatoren und Verstärker.

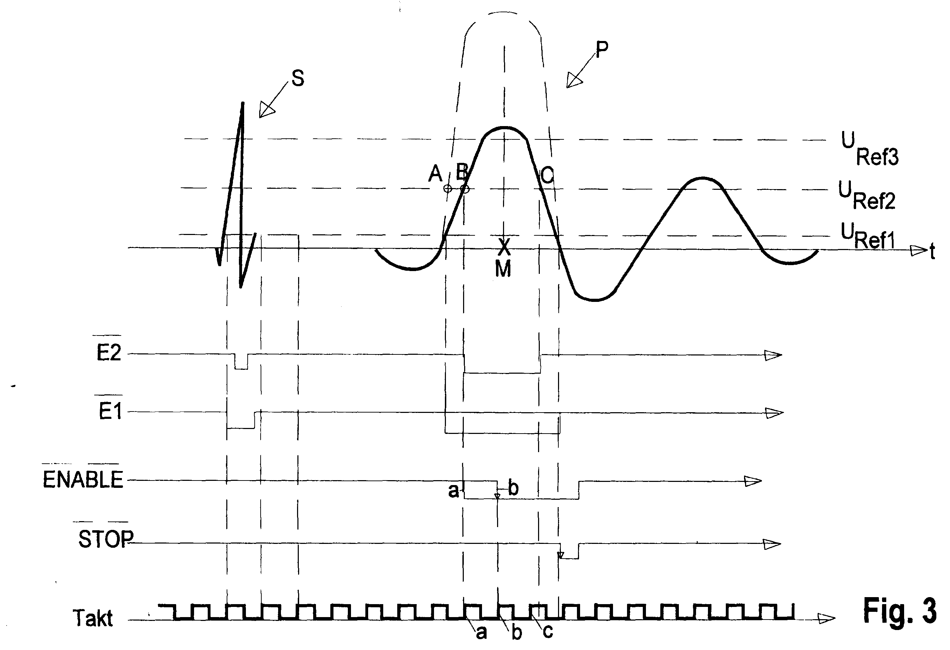

Aus der US-A-5,640,109 ist ein Impulsdetektor zur Detektion von elektrischen Impulsen mit variierenden Amplitudenmaxima bekannt. Der Detektor besteht aus einem ersten Komparator zur Amplitudenspitzenwertabfrage, einem zweiten Komparator zur Signaldetektion, einem Integrator, dessen Spannungssignal dem Spitzenwert in Schritten nachgeführt wird, und aus einem Steuerelement zum zeit- und. amplitudenabhängigen Nachführen des Schaltpunktes des zweiten Komparators. Die Schaltschwelle des zweiten Komparators ist jedoch nicht nullpunktnah, so daß bei starken Amplitudenänderungen des Positionssignals beträchtliche Meßfehler durch eine Verschiebung der Signalflanken (Walking Effect, vgl. Meßpunkte A, B in Fig. 3) im Ausgangssignal des zweiten Komparators verursacht werden können. Das schrittweise Nachführen des Schaltpunktes des zweiten Komparators wirkt diesem Fehler nur ungenügend entgegen. Darüber hinaus ist die Kombination von amplituden- und laufzeitabhängig nachgeführtem Schaltpunkt besonders aufwendig.

Es ist daher die Aufgabe der vorliegenden Erfindung, einen Impulsdetektor und ein Detektionsverfahren zu schaffen, das bezüglich der Amplitude der zu erfassenden Impulse möglichst invariant ist und das eine hohe Störfestigkeit aufweist.

Die Erfindung schafft einen Impulsdetektor zur Detektion von sinusförmigen Impulsen durch Erfassung eines Schaltpunktes nahe dem Nulldurchgang des Impulssignals. Der Impulsdetektor umfaßt einen Komparator, dessen einer Eingang mit dem elektrischen Impulssignal gespeist wird und dessen anderer Eingang an einer vorgegebenen Referenzspannung liegt, die auf einen nullpunktnahen Wert eingestellt ist, und eine Logikeinheit mit einem Signaleingang, der mit dem Ausgang des Komparators verbunden ist. Die Logikeinheit tastet das Ausgangssignal des Komparators mit einer vorgegebenen Abtastfrequenz ab und erzeugt erst dann ein internes Signal (IMPULS-ERFASST), wenn mehrere gültige Abtastwerte in Folge vorliegen, wobei das interne Signal vorzugsweise zwischengespeichert wird. Dabei ergibt die Abtastung einen 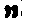 gültigen" Wert, solange das Impulssignal über der Schaltschwelle des Komparators liegt. Bei Unterschreiten des Impulssignals unter die nullpunktnahe Referenzspannung und gleichzeitigem Vorliegen eines IMPULS-ERFASST-Signals wird ein Impulsdetektorausgangssignal (STOP) erzeugt. Dadurch, daß das Impulssignal abgetastet wird und mehrere gültige Abtastwerte in Folge vorliegen müssen, um die Ausgabe eines Impulsdetektorausgangssignals (STOP) zu ermöglichen, werden kurze Störimpulse (vgl. S in Fig. 3) nicht erfaßt und somit die Störfestigkeit erheblich verbessert. Die Abtastwerte werden vorzugsweise von einem Zähler summiert, der jeweils nach einem vorgegeben Zeitintervall zurückgesetzt wird. Das Impulsdetektorausgangssignal (STOP) ist z.B. ein Einbitsignal, das von einer Auswerteeinheit ausgewertet wird. Bei Verwendung des Detektors in einem magnetostriktiven Positionssensor kann aber auch die Zeitspanne zwischen der Auslösung eines Erregerstromimpulses (START) im Erregerstromkreis des Positionssensors und der Erfassung des elektrischen Impulssignals am Detektor bereitgestellt werden.

Gemäß einer zweiten Ausführungsform umfaßt der Impulsdetektor einen ersten Komparator, dessen einer Eingang mit dem Impulsdetektoreingang, an dem das auszuwertende Impulssignal anliegt, verbunden ist, und dessen anderer Eingang an einer vorgegebenen ersten Referenzspannung liegt, und einen zweiten Komparator, dessen einer Eingang ebenfalls mit dem Systemeingang verbunden ist, und dessen anderer Eingang an einer zweiten vorgegebenen Referenzspannung liegt, wobei eine der Referenzspannungen entweder direkt auf Signalmasse oder auf einen nullpunktnahen Wert eingestellt ist und die andere Referenzspannung betragsmäßig größer ist. 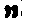 Nullpunktnah" bedeutet im folgenden, daß der betreffende Schwellenwert im unteren Drittel der Amplitudenhöhe des Impulssignals oder direkt auf Signalmasse liegt. Ferner ist eine Logikeinheit vorgesehen, deren Eingang an dem Ausgang des zweiten Komparators angeschlossen ist. Dadurch, daß das Ausgangssignal des zweiten Komparators mit einer vorgegebenen Abtastfrequenz abgetastet wird und wenigstens ein gültiger Abtastwert vorliegen muß, um die Ausgabe eines Impulsdetektorausgangssignals (STOP) zu ermöglichen, werden kurze Störimpulse (vgl. S in Fig. 3) nicht erfaßt, und somit die Störfestigkeit erheblich verbessert. Wenn das Impulssignal die nullpunktnahe Referenzspannung unterschreitet, wird nur dann ein Detektorausgangssignal generiert, wenn zuvor wenigstens ein gültiger Abtastwert ermittelt wurde.

Die zweite Referenzspannung ist vorzugsweise betragsmäßig größer und besitzt die gleiche Polarität wie die erste Referenzspannung. Gemäß einem weiteren Aspekt der Erfindung kann die zweite Referenzspannung bei stark variierenden Amplitudenmaxima des Impulssignals der Amplitudenhöhe proportional nachgeführt werden, so daß die durch die zweite Referenzspannung vorgegebene Schaltschwelle immer im mittleren Bereich und vorzugsweise im mittleren Drittel der Amplitudenhöhe des Impulssignals liegt. Zu diesem Zweck weist der Impulsdetektor einen dritten Komparator auf, dessen einer Eingang mit dem Impulssignal gespeist wird und dessen anderer Eingang an einer einstellbaren dritten Referenzspannung liegt, die auf einen Wert nahe dem Amplitudenspitzenwert des Impulssignals eingestellt ist. Der Ausgang des dritten Komparators ist mit einem zweiten Eingang der Logikeinheit verbunden. Die Logikeinheit stellt fest, ob das Impulssignal den dritten Schwellenwert übersteigt, und hebt den zweiten und dritten Schwellenwert an bzw. verringert diesen, falls die Amplitude des Impulssignals größer bzw. kleiner ist als der dritte Schwellenwert.

Gemäß einem ersten erfindungsgemäßen Detektionsverfahren wird das auszuwertende Impulssignal erfaßt und festgestellt, ob das Impulssignal einen vorgegebenen, nullpunktnahen Schwellenwert übersteigt. Bei Überschreiten des nullpunktnahen Schwellenwerts wird ein erstes Erfassungssignal erzeugt. Dieses wird mit einer vorgegebenen Tastfrequenz abgetastet. Wenn mehrere gültige Abtastwerte in Folge vorliegen wird ein internes Freigabe- bzw. Aktivierungssignal erzeugt, so daß bei Unterschreiten des Impulssignals unter den nullpunktnahen Schwellenwert ein Detektorausgangssignal erzeugt werden kann.

Gemäß einem zweiten erfindungsgemäßen Detektionsverfahren wird das auszuwertende Impulssignal erfaßt und festgestellt, ob das Impulssignal einen ersten, nullpunktnahen Schwellenwert übersteigt. Bei Überschreiten des ersten Schwellenwerts wird ein erstes Erfassungssignal erzeugt. Ferner wird ein zweiter Schaltpunkt erfaßt, an dem das Positionssignal einen zweiten Schwellenwert übersteigt, der betragsmäßig größer ist als der erste Schwellenwert. Bei Überschreiten des zweiten Schwellenwerts wird ein zweites Erfassungssignal erzeugt. Anschließend wird vorzugsweise das zweite Erfassungssignal abgetastet und bei Unterschreiten des nullpunktnahen Schwellenwertes ein Detektorausgangssignal erzeugt, wenn wenigstens ein gültiger Abtastwert vorliegt.

Um auch bei stark variierenden Amplitudenmaxima des Impulssignals eine optimale Signalauswertung zu ermöglichen, wird gemäß einem anderen Aspekt der Erfindung ein dritter Schwellenwert nahe dem Amplitudenspitzenwert bereitgestellt und ein drittes Erfassungssignal erzeugt, wenn die Amplitude des Impulssignals den dritten Schwellenwert überschreitet. Dieses dritte Erfassungssignal wird von einer Logikeinheit ausgewertet, die den zweiten und dritten Schwellenwert anhebt bzw. verringert, falls die maximale Amplitude des Impulssignals größer bzw. kleiner ist als der dritte Schwellenwert.

Anstelle den dritten Schwellenwert bei jedem eintreffenden Impulssignal nachzuführen kann der Schwellenwert auch erst nach einer bestimmten Anzahl von Impulsen neu eingestellt werden. Dazu werden die dritten Erfassungssignale in einem vorgegebenen Zeitintervall gezählt und mit der Anzahl der tatsächlich dem Detektor zugeführten Impulssignale verglichen. Der dritte Schwellenwert wird nachgeführt, wenn die Anzahl der Erfassungssignale einen vorgegebenen Sollwert übersteigt bzw. unterschreitet.

Zur Vermeidung von Meßfehlern ist es vorteilhaft, den für die Auswertung des Impulssignals maßgeblichen Schaltpunkt möglichst nullpunktnah festzulegen oder direkt auf Signalmasse zu beziehen, da ein solcher Schaltpunkt auch bei stark variierenden Amplitudenhöhen bezüglich des Zeitpunkts des Signaldurchgangs nahezu invariant bleibt. Ein weiterer amplitudeninvarianter Meßpunkt ist der Zeitpunkt des Amplitudenscheitelwerts des Impulssignals, der erfindungsgemäß über eine Mittelwertberechnung ermittelt wird.

Ein erfindungsgemäßer Impulsdetektor zur Detektion von sinusförmigen Impulsen durch Ermittlung der Symmetrielinie einer Halbwelle des Impulssignals umfaßt einen Komparator, dessen einer Eingang mit elektrischen Impulssignalen gespeist wird, und dessen anderer Eingang an einer vorgegebenen Referenzspannung liegt. Der Ausgang des Komparators ist mit einer Logikeinheit verbunden. Bei Überschreiten des durch die Referenzspannung vorgegebenen Schwellenwertes wird der Komparatorausgang aktiviert und bei Unterschreiten des Schwellenwertes deaktiviert. Dabei braucht die Referenzspannung nicht nullpunktnah zu sein, sondern kann einen beliebigen Wert innerhalb der Amplitudenhöhe einnehmen. Die Logikeinheit wertet die beiden Ereignisse aus und berechnet daraus einen Mittelwert, der dem Zeitpunkt des Amplitudenspitzenwertes entspricht.

Anstelle nur eines Komparators für die steigende und fallende Flanke des Impulssignals können auch mehrere Komparatoren verwendet werden, die jeweils nur den Schaltpunkt der steigenden Flanke oder nur den Schaltpunkt der fallenden Flanke ermitteln. Eine Schaltpunktnachführung mittels eines weiteren Komparators mit einer weiteren Referenzspannung nahe dem Amplitudenspitzenwert, wie oben beschrieben wurde, ist ebenfalls zweckmäßig.

Das erfindungsgemäße Detektionsverfahren zur Erfassung von elektrischen Impulssignalen durch Ermittlung der Symmetrielinie einer Halbwelle des Impulssignals umfaßt folgende Schritte:

Erfassen eines ersten Schaltpunktes, an dem das Impulssignal einen vorgegebenen Schwellenwert übersteigt und Erzeugen eines ersten Signals (bzw. einer Signaländerung) bei Überschreiten des Schwellenwertes; Erfassen eines zweiten Schaltpunktes, wenn das Impulssignal den Schwellenwert wieder unterschreitet, und Erzeugen eines Signals (bzw. einer Signaländerung). Aus den beiden Ereignissen wird sodann der Symmetriepunkt ermittelt und ein Impulsdetektorausgangssignal ausgeben, das vorzugsweise dem Zeitintervall zwischen der Auslösung eines Erregerimpulses (START) in einem Erregerstromkreis eines Impulsgenerators und dem Symmetriepunkt zwischen den beiden Signalen entspricht. Die Auswertung der Signale erfolgt vorzugsweise durch einen Integrator und einen Mikrocontroller zur Mittelwertberechnung.

Zu den Eingangs genannten Einflußgrößen, die sowohl die Amplitudenhöhe des erzeugten Positionsimpulses als auch das Stör-/Nutzsignal-Verhältnis des auszuwertenden elektrischen Positionssignals beeinflussen, gehört auch die Stärke des Erregerstromimpulses im Erregerstromkreis des magnetostriktiven Positionssensors. Zugunsten einer optimalen Signalauswertung ist es erforderlich, diesen Parameter möglichst konstant zu halten. Zu diesem Zweck umfaßt ein Spannungshochsteller des magnetostriktiven Positionssensors einen Schalter, der bei Überschreiten der Ausgangsspannung über einen vorgegebenen Grenzwert so lange geschlossen wird, bis die Ausgangsspannung wieder auf den Grenzwert abgesunken ist. Auf diese Weise wird sichergestellt, daß die Ausgangsspannung des Hochstellers und damit die Stärke des Erregerstromimpulses konstant bleibt. Die Überwachung der Ausgangsspannung und das Schalten des Schalters erfolgt mit Hilfe einer Steuereinheit.

Nachfolgend werden mehrere Ausführungsformen der Erfindung bezüglich der beigefügten Zeichnungen beispielhaft näher erläutert. Es zeigen
Fig. 1 ein Blockschaltbild einer ersten Ausführungsform eines erfindungsgemäßen Impulsdetektors zur nullpunktnahen Auswertung eines Impulssignals;
Fig. 2 ein Blockschaltbild einer zweiten Ausführungsform eines erfindungsgemäßen Impulsdetektors zur nullpunktnahen Auswertung eines Impulssignals;
Fig. 3 ein typisches auszuwertendes Impulssignal und verschiedene andere Signale des Impulsdetektors nach Fig. 1 bzw. 2;
Fig. 4 einen Impulsdetektor gemäß Fig. 2 mit zusätzlicher Schaltpunktnachführung;
Fig. 5 einen erfindungsgemäßen Impulsdetektor zur Erfassung eines sinusförmigen Impulses durch Ermittlung des Symmetriepunktes einer Halbwelle des Impulssignals;
Fig. 6 einen Impulsdetektor als Bestandteil eines magnetostriktiven Positionssensors.
Fig. 7 den Spannungsverlauf der Ausgangsspannung eines Spannungshochstellers.

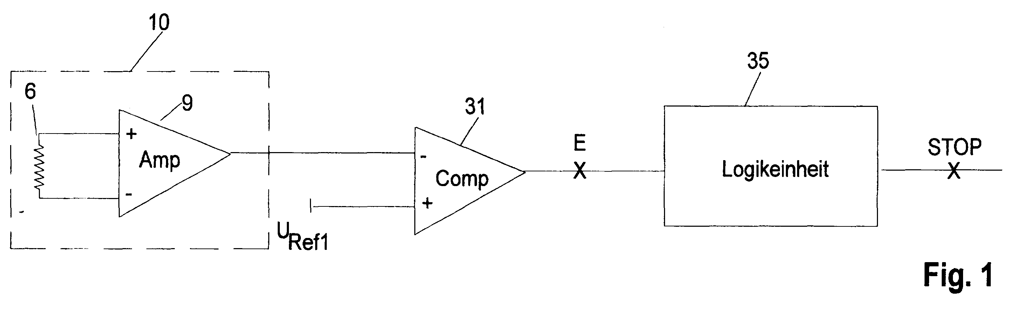

Fig. 1 zeigt das Prinzipschaltbild eines Impulsdetektors zur Detektion von sinusförmigen Impulsen eines magnetostriktiven Positionssensors. Die in einem solchen Wegmeßsystem angeregten magnetoelastischen Positionsimpulse breiten sich entlang eines magnetostriktiven Wellenleiters aus und werden an einem Meßpunkt von einer Aufnehmerspule 6 erfaßt. Der in der Aufnehmerspule 6 erzeugte Spannungsimpuls wird mit einem Verstärker 9 verstärkt, dessen Ausgang mit dem Eingang des Impulsdetektors verbunden ist. Aufnehmerspule 6 und Verstärker 9 bilden zusammen einen Modenwandler 10. Der Impulsdetektor umfaßt einen Komparator 31, dessen invertierender Eingang mit dem verstärkten Impulssignal gespeist wird und dessen nicht invertierender Eingang an einer Referenzspannung U_{Ref1} liegt, die auf einen nullpunktnahen Wert eingestellt ist. Eine Logikeinheit 35 ist mit dem Ausgang des Komparators verbunden. Die Logikeinheit tastet das Ausgangssignal des Komparators mit einer vorgegebenen Abtastfrequenz ab und erzeugt erst dann ein internes Signal (IMPULS-ERFASST), wenn mehrere gültige Abtastwerte in Folge vorliegen. Bei Unterschreiten des Impulssignals unter die nullpunktnahe Referenzspannung und gleichzeitigem Vorliegen eines IMPULS-ERFASST-Signals wird ein Impulsdetektorausgangssignal (STOP) erzeugt. Das Impulsdetektorausgangssignal (STOP) ist z.B. ein Einbitsignal, das von einer Auswerteeinheit ausgewertet wird. Bei Verwendung des Detektors in einem magnetostriktiven Positionssensor kann aber auch die Zeitspanne zwischen der Auslösung eines Erregerstromimpulses (START) im Erregerstromkreis des Positionssensors und der Erfassung des elektrischen Impulssignals am Detektor bereitgestellt werden.

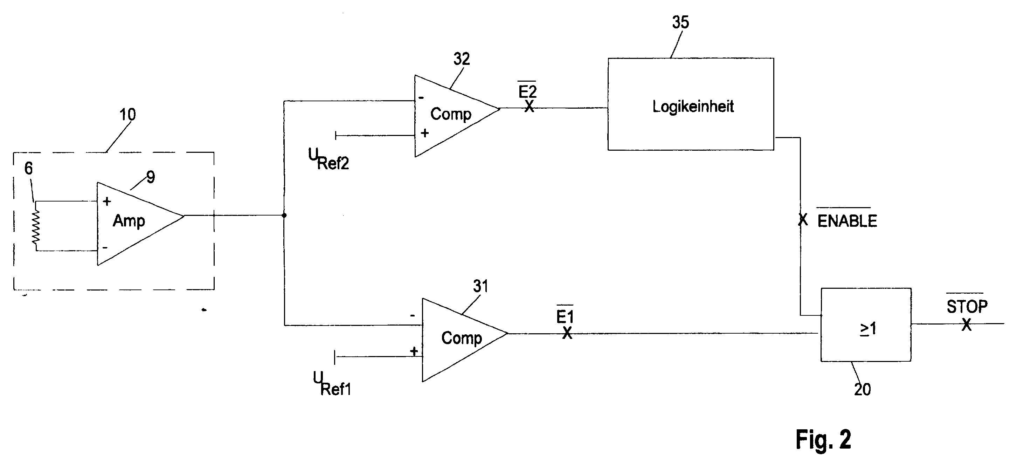

Der Impulsdetektor gemäß Fig. 2 umfaßt einen ersten Komparator 31, dessen invertierender Eingang mit dem verstärkten Impulssignal gespeist wird und dessen nicht invertierender Eingang an einer ersten Referenzspannung U_{Ref1} liegt, und einen zweiten Komparator 32, dessen invertierender Eingang mit dem Eingang des Impulsdetektors verbunden ist und dessen nicht invertierender Eingang an einer zweiten Referenzspannung U_{Ref2} liegt. Die erste Referenzspannung U_{Ref1} ist auf einen nullpunktnahen Wert eingestellt, während die zweite Referenzspannung auf einen Wert im mittleren Bereich der Amplitude des Impulssignals eingestellt ist. Beide Schaltpunkte der Komparatoren 31 und 32 sind von gleicher Polarität. Der Ausgang des Komparators 32 ist mit einem Eingang einer Logikeinheit 35 verbunden, die das Ausgangssignal des zweiten Komparators 32 mit einer vorgegebenen Abtastfrequenz abtastet und nur dann ein Ausgangssignal ENABLE bereitstellt, wenn wenigstens ein gültiger Abtastwert vorliegt. Der Ausgang des ersten Komparators 31 und der Ausgang der Logikeinheit 35 sind jeweils mit einem Eingang eines OR-Gatters 20 verbunden, an dessen Ausgang das maßgebliche Meßsignal STOP erzeugt wird.

Die Funktion der Impulsdetektoren nach Fig. 1 bzw. 2 wird anhand der Signalverläufe in Fig. 3 besser verständlich.

Fig. 3 zeigt zunächst einen typischen Signalverlauf eines Impulssignals P, wie es am Eingang eines Impulsdetektors anliegt. Nach einer negativen Halbwelle überschreitet die steigende Flanke des Impulssignals P zunächst eine nullpunktnahe erste Schaltschwelle U_{Ref1,} wodurch der Ausgang des ersten Komparators 31 seinen Schaltzustand ändert und ein erstes Erfassungssignal E₁ erzeugt. Nach einem weiteren Anstieg überschreitet das Impulssignal P die zweite Schaltschwelle U_{Ref2} des zweiten Komparators 32, der ebenfalls seinen Schaltzustand ändert und ein zweites Erfassungssignal E₂ erzeugt. Dieses wird von der Logikeinheit 35 mit einer vorgegebenen Abtastfrequenz (Takt) abgetastet. Nur wenn wenigstens ein gültiger Abtastwert vorliegt wird ein Ausgangssignal ENABLE erzeugt. Bei einer Einfachauswertung des zweiten Erfassungssignals E₂ am Ausgang des zweiten Komparators 32 reicht bereits ein Taktimpuls a aus, um den Schaltzustand des ENABLE-Signals zu ändern. Bei einer Mehrfachauswertung sind wenigstens zwei aufeinanderfolgende Taktimpulse a, b der Taktfrequenz (Takt) mit jeweils gültigen Abtastwerten erforderlich, um eine Änderung des Schaltzustandes am Ausgang der Logikeinheit 35 zu bewirken. Der Verlauf des ENABLE-Signals zeigt eine Änderung des Schaltzustandes an Punkt b bei Zweifachauswertung. Die Abtastung erfolgt in diskreten Zeitpunkten an den steigenden Flanken der Taktimpulse a, b, c.

Ein durch elektrisches Rauschen verursachter kurzer Störimpuls S wird nicht fälschlicherweise als Impulssignal interpretiert, da zu den diskreten Abtastzeitpunkten der Taktimpulse a, b, c das Störsignal S die zweite Schaltschwelle U_{ref2} nicht überschritten hat und somit kein gültiger Abtastwert erzeugt wird. Durch eine Auswertung mehrerer aufeinanderfolgender Abtastwerte führt auch eine zufällige Fehlerkennung an nur einem diskreten Zeitpunkt nicht zu einem STOP-Signal. Nach der Erfassung eines Impulssignals P wird das ENABLE-Signal zurückgesetzt, um eine mehrfache Auslösung eines STOP-Signals durch spätere Halbwellen der gleichen Sinuswelle zu verhindern. Zu diesem Zweck ist vorzugsweise ein Zeitzähler vorgesehen, der bei einer Signaländerung des ENABLE-Signals startet und das ENABLE-Signal nach einer Verzögerungszeit, die größer ist als das maximal erwartete Zeitintervall der auszuwertenden Halbwelle des Impulssignals, zurücksetzt.

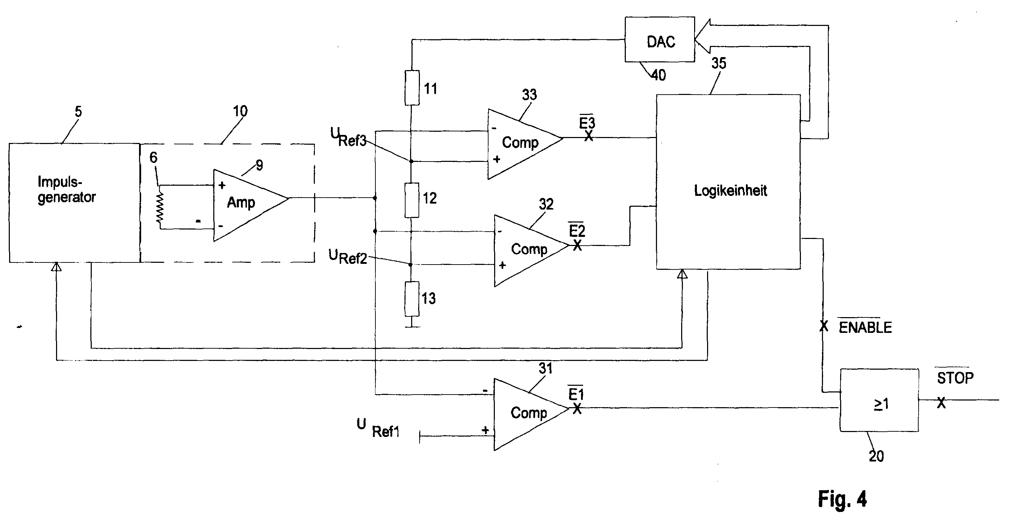

Fig. 4 zeigt einen Impulsdetektor nach Fig. 1 mit zusätzlicher Schaltpunktnachführung. Der Impulsdetektor umfaßt neben den Komparatoren 31 und 32 einen weiteren dritten Komparator 33, dessen invertierender Eingang am Signaleingang des Impulsdetektors liegt und dessen nicht invertierender Eingang auf einer einstellbaren dritten Referenzspannung U_{Ref3} gehalten wird, die auf einen amplitudennahen Wert eingestellt ist. Der Ausgang des dritten Komparators 33 ist mit einem zweiten Eingang der Logikeinheit 35 verbunden, die über einen Digital-Analogwandler 40 den Wert der dritten und mittelbar auch der zweiten Referenzspannung U_{Ref2}, U_{Ref3} der variierenden Amplitudenhöhe des Impulssignals P nachführt. Der Referenzeingang des dritten Komparators 33 ist über einen Spannungsteiler 12, 13 mit dem Referenzeingang des zweiten Komparators verbunden, so daß auch die an dem nicht invertierenden Eingang des Komparators 32 anliegende Referenzspannung U_{Ref2} verschiedenen Amplitudenhöhen des Impulssignals P angepaßt wird. Dagegen bleibt die erste Referenzspannung U_{Ref1} konstant.

Sofern eine Schaltpunktnachführung nicht nach jedem eintreffenden Positionsimpuls P erfolgen soll, kann die Logikeinheit 35 einen Zähler aufweisen, der innerhalb eines vorgegebenen Zeitintervalls die Anzahl der Impulssignale P erfaßt, deren Amplitude größer ist als die dritte Referenzspannung U_{Ref3}. Nach einem Soll-Ist-Vergleich stellt die Logikeinheit einen Ausgangswert bereit, der die Referenzspannungen U_{Ref2} und U_{Ref3} den variierenden Amplituden der Impulssignale P nachführt. Die Werte der genannten Referenzspannungen U_{Ref2,} U_{Ref3} werden angehoben, falls die Amplitude des Impulssignals P größer ist als die dritte Referenzspannung oder die Anzahl der in dem überwachten Zeitintervall von dem Komparator 33 erfaßten Impulssignale P größer ist als ein vorgegebener Referenzwert. Falls die Amplitude eines Impulssignals kleiner ist als die dritte Referenzspannung U_{Ref3} oder die Anzahl der von dem dritten Komparator 33 in dem überwachten Zeitintervall erfaßten Positionsimpulse kleiner ist als ein vorgegebener Referenzwert, wird die Schaltschwelle des dritten Komparators gesenkt.

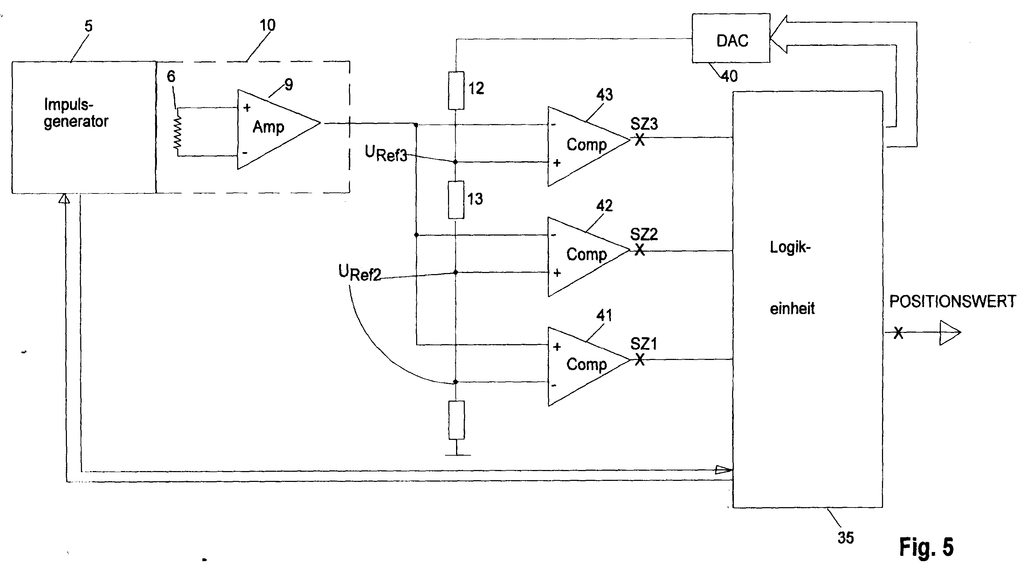

Fig. 5 zeigt einen Impulsdetektor zur Detektion von sinusförmigen Positionsimpulsen auf einem magnetostriktiven Positionssensor durch Erfassen jeweils eines Schaltpunktes der ansteigenden und fallenden Flanke einer Halbwelle eines Impulssignals P. Der Impulsdetektor umfaßt drei Komparatoren 41, 42, 43, wobei der Referenzeingang der Komparatoren 41, 42 an derselben Referenzspannung U_{Ref2} liegt, während der nicht invertierende Eingang des ersten Komparators 41 bzw. der invertierende Eingang der Komparatoren 42 und 43 mit dem Ausgang des Modenwandlers 10 verbunden sind. Der dritte Komparator 43 dient in bekannter Weise zur Nachführung des Schaltpunktes des zweiten Komparators 42. Die Funktion des Impulsdetektors wird durch Betrachtung von Fig. 3 besser verständlich.

Die Referenzspannung der Komparatoren 41 und 42 liegt beispielsweise auf einem Wert U_{Ref2} in Fig. 3. Bei Überschreiten der Schaltschwelle in Punkt B erzeugt der Komparator 41 durch Änderung seines Ausgangs ein erstes Stopp-Zeitsignal SZ1, während der Komparator 42 ein zweites Stopp-Zeitsignal SZ2 erzeugt, wenn die fallende Flanke des Impulssignals P in Punkt C den vorgegebenen Schwellenwert unterschreitet. Die Logikeinheit 35 erfaßt die Stopp-Zeitsignale SZ1 und SZ2 und errechnet die Differenzen beider Signale bezüglich des Signals START und bestimmt den Mittelwert aus beiden Differenzzeitspannen. Dieser Mittelwert kann mittels eines TDC (Zeit zu Digital-Wandler) oder eines Integrators berechnet werden. An einem Ausgang POSITIONSWERT der Logikeinheit 35 wird schließlich der aus der Laufzeit errechnete Positionswert in Form eines analogen Spannungswertes oder in Form eines digital kodierten Zahlenwertes ausgegeben. Die Referenzspannung U_{Ref2} der Komparatoren 41 und 42 ist wiederum ein Bruchteil der Referenzspannung U_{Ref3} des dritten Komparators 43. In Betrieb steuert die Logikeinheit 35, die vorzugsweise als Mikrocontroller ausgebildet ist, einen Impulsgenerator 5, um magnetoelastische Positionsimpulse auf dem Wellenleiter anzuregen, die durch den Modenwandler 10 in entsprechende elektrische Spannungsimpulse umgewandelt werden. Ein geeigneter Impulsgenerator ist in der PCT-Anmeldung der Firma ASM GmbH Nr.PCT/EP98/02108 offenbart, auf die nachfolgend Bezug genommen wird.

Auf Anforderung der Logikeinheit 35 erzeugt ein Erregerstromkreis des Impulsgenerators 5 einen kurzen Stromimpuls. Der Logikeinheit 35 wird daraufhin angezeigt, daß durch den Impulsgenerator 6 ein Erregerimpuls auf dem Wellenleiter ausgelöst wurde. Dieses Signal (START) bedingt den Anfang des Meßintervalls, das bis zum Eintreffen des Impulssignals (STOP) dauert. Am Ausgang der Logikeinheit 35 wird schließlich die errechnete Laufzeit des magnetoelastischen Positionsimpulses ausgegeben. Die Messung der Zeitintervalle zwischen dem START- und dem ersten bzw. zweiten Stopp-Zeitsignal kann mittels eines TDC (Zeit-/Digitalwandler) oder mittels eines Integrators erfolgen. Der Integrator arbeitet zwischen dem START- und dem ersten Stopp-Zeitsignal SZ1 vorzugsweise mit einer ersten Integrationskonstante und danach mit der halben Integrationskonstante.

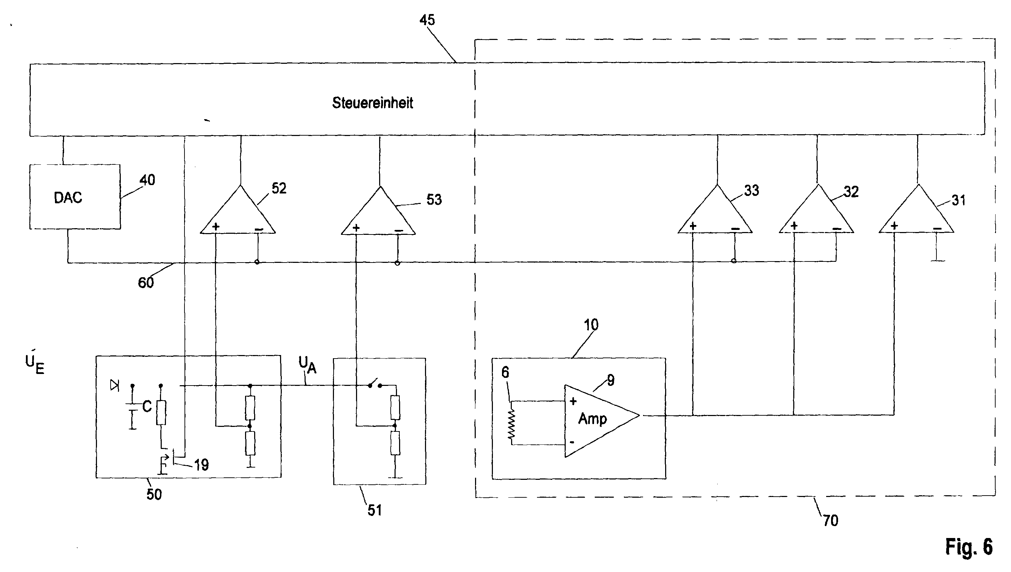

Fig. 6 zeigt einen magnetostriktiven Positionssensor mit Impulsgenerator 50, 51 und einem Impulsdetektor 70 mit vorgeschaltetem Modenwandler 10. Um bei der meßtechnischen Nutzung eines magnetostriktiven Positionssensors hohe Meßgenauigkeit und hohe Störsicherheit zu erzielen, ist es einerseits notwendig, magnetoelastische Impulse mit genau vordefinierter und gleichbleibender Amplitude im Wellenleiter zu erzeugen und andererseits diese Impulse bei bestmöglichem Stör-/Nutzsignalverhältnis zu erkennen und auszuwerten. Mit dem in Fig. 6 gezeigten System ist es nun möglich, die Amplitudenhöhe des Positionsimpulssignals, des Erregungsimpulssignals (Erregerstromimpuls) und die Erregerspannung des Impulsgenerators zu erfassen. Dazu werden diesen Größen mit analogen Referenzwerten verglichen. Zur Messung der Erregerspannung des Impulsgenerators wird diese in dem Hochsteller 50 abgegriffen und an einen Signaleingang eines Komparators 52 geführt. Das Erregungsimpulssignal des Impulsgenerators wird in dem Erregerstromkreis 51 abgegriffen und einem Signaleingang eines weiteren Komparators 53 zugeführt. Die Amplitude des Positionsimpulssignals wird, wie oben beschrieben, von den Komparatoren 31, 32 und 33 erfaßt. Die Referenzeingänge der Komparatoren 31, 32, 33, 52 und 53 liegen alle auf einer gemeinsamen Leitung 60, die den Ausgang eines D/A-Wandlers bildet.

Aufgrund der unterschiedlichen Zeitpunkte von Impulserregung und Impulserfassung kann die jeweils benötigte Referenzspannung für alle drei Größen auf einer einzigen Leitung 60 zeitsequentiell bereitgestellt werden. Die Steuerung der zeitsequentiellen Messung und die Auswertung der Ausgangssignale der Komparatoren 31, 32, 33, 52 und 53 erfolgt durch eine Steuereinheit 45. Die Steuereinheit 45 hält an ihrem Steuerausgang binäre Referenzwerte bereit, die vorzugsweise zwischengespeichert sind, um vor allem das binäre Vergleichssignal für das schnell zeitvariante Positionsimpulssignal und Erregungsimpulssignal sicher ausgeben zu können. Der Steuerausgang der Steuereinheit 45 liegt an einem D/A-Wandler, der vorzugsweise mit Hilfe eines Widerstandsnetzwerkes realisiert ist. Jeder der Widerstände (nicht gezeigt) ist vorzugsweise auf einen Summierknoten geschaltet, so daß eine große Anzahl von Vergleichswerten mit Hilfe einer relativ geringen Anzahl von Widerständen realisierbar ist.

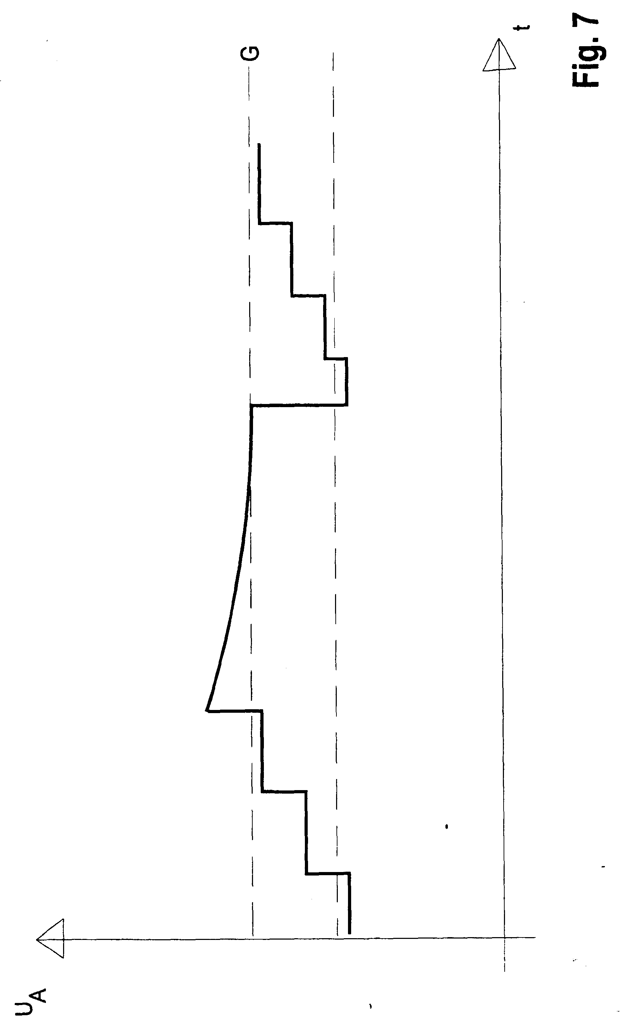

Die Gleichmäßigkeit der Erregungsimpulssignale wird gemäß einem anderen Aspekt der Erfindung dadurch verbessert, daß die Erregerspannung auf einen festen Wert geregelt wird (Fig. 7). Beim Aufladen eines Speicherkondensators C durch Strompulse einer Induktivität wird eine gewünschte Erregerspannung U_{A} meist nicht genau erreicht, da eine Aufladung des Speicherkondensators C nur in diskreten Spannungsstufen erfolgt. Bei Überschreiten eines vorgegeben Grenzwertes wird daher die Kondensatorspannung wieder auf den Grenzwert abgesenkt. Zu diesem Zweck ist ein Schalter 19 vorgesehen, dessen Steuereingang mit der Steuereinheit verbunden ist und der solange geschlossen wird, bis der gewünschte Grenzwert erreicht ist. Die aktuelle Erregerspannung wird dabei ständig durch den Komparator 52 an die Steuereinheit 45 überwacht, wobei die Referenzspannung des Komparators 52 auf dem erwünschten Grenzwert G der Erregerspannung U_{A} eingestellt ist.

## Patentansprüche

1. Impulsdetektor zur Detektion von sinusförmigen Impulsen durch Erfassung eines Schaltpunktes nahe dem Nulldurchgang eines Impulssignals, umfassend
- einen Komparator (31), dessen einer Eingang mit dem elektrischen Impulssignal gespeist wird und dessen anderer Eingang an einer vorgegebenen Referenzspannung (U_{Ref1}) liegt, die auf einen nullpunktnahen Wert eingestellt ist,
- eine Logikeinheit (35) mit einem Signaleingang, der mit dem Ausgang des Komparators (31) verbunden ist,
**dadurch gekennzeichnet, daß**
- die Logikeinheit (35) das Ausgangssignal des Komparators (31) mit einer vorgegebenen Abtastfrequenz abtastet und erst dann ein internes Aktivierungssignal erzeugt, wenn mehrere gültige Abtastwerte vorliegen, so daß
- bei Unterschreiten des Impulssignals (P) unter die nullpunktnahe Referenzspannung (U_{Ref1}) und Vorliegen eines Aktivierungssignals ein Impulsdetektorausgangssignal (STOP) erzeugt wird.

2. Verfahren zur Detektion von sinusförmigen Impulsen durch Erfassung eines Schaltpunktes nahe dem Nulldurchgang eines Impulssignals, umfassend folgende Schritte:
- Erfassen eines Schaltpunktes, an dem das Impulssignal (P) einen nullpunktnahen Schwellenwert (U_{Ref1}) übersteigt, und Erzeugen eines Erfassungssignals (E) bei Überschreiten des Schwellenwerts (U_{Ref1}),
- Abtasten des Erfassungssignals (E) mit einer vorgegebenen Tastfrequenz, und Erzeugen eines Aktivierungssignals, wenn mehrere gültige Abtastwerte in Folge ermittelt wurden, und
- Erzeugen eines Impulsdetektorausgangssignals (STOP), wenn das Impulssignal (P) den nullpunktnahen Schwellenwert (U_{Ref1}) unterschreitet und gleichzeitig ein Aktivierungssignal vorliegt.

3. Impulsdetektor zur Detektion von sinusförmigen Impulsen durch Erfassung eines Schaltpunktes nahe dem Nulldurchgang eines Impulssignals, umfassend
- einen ersten Komparator (31), dessen einer Eingang mit dem elektrischen Impulssignal (P) gespeist wird und dessen anderer Eingang an einer vorgegebenen ersten Referenzspannung (U_{Ref1}) liegt,
- einen zweiten Komparator (32), dessen einer Eingang mit dem elektrischen Impulssignal gespeist wird und dessen anderer Eingang an einer vorgegebenen zweiten Referenzspannung (U_{Ref2}) liegt, wobei die erste Referenzspannung (U_{Ref1}) auf einen nullpunktnahen Wert und die zweite Referenzspannung (U_{Ref2}) auf einen betragsmäßig größeren Wert eingestellt ist, der kleiner ist als die maximale Amplitude des Impulssignals (P),
- eine Logikeinheit (35) mit einem Signaleingang, der mit dem Ausgang des zweiten Komparators (32) verbunden ist,
**dadurch gekennzeichnet, daß**
- die Logikeinheit (35) das Ausgangssignal (E2) des zweiten Komparators (32) mit einer vorgegebenen Abtastfrequenz abtastet und erst dann ein Signal (ENABLE) erzeugt, wenn wenigstens ein gültiger Abtastwert vorliegt, so daß
- bei Unterschreiten des Impulssignals unter die nullpunktnahe Referenzspannung (U_{Ref1}) und Vorliegen eines ENABLE-Signals ein Impulsdetektorausgangssignal (STOP) erzeugt wird.

4. Impulsdetektor nach Anspruch 3,
**dadurch gekennzeichnet, daß**
die zweite Referenzspannung (U_{Ref2}) auf einen Wert im mittleren Drittel der maximalen Amplitude des Impulssignals (P) und die erste Referenzspannung (U_{Ref1}) auf einen Wert im unteren Drittel des Impulssignals (P), nahe dem Nullpunkt, oder auf den Nullpunkt selbst eingestellt ist.

5. Impulsdetektor nach einem der Ansprüche 3 oder 4,
**dadurch gekennzeichnet, daß**
die Logikeinheit (35) ein Mikrocontroller ist und die Abtastung des Impulssignals (P) mit dem Systemtakt erfolgt.

6. Impulsdetektor nach einem der Ansprüche 3 bis 5,
**dadurch gekennzeichnet, daß**
beide Referenzspannungen (U_{Ref1,} U_{Ref2}) gleicher Polarität sind.

7. Impulsdetektor nach einem der Ansprüche 3 bis 6,
**dadurch gekennzeichnet, daß**
das ENABLE-Signal der Logikeinheit (35) und das Ausgangssignal des ersten Komparators (31) jeweils an einem Eingang eines Logikgatters (20) liegen, das bei Unterschreiten der nullpunktnahen ersten Referenzspannung (U_{Ref1}) und Vorliegen des ENABLE-Signals das STOP-Signal am Ausgang des Impulsdetektors erzeugt.

8. Impulsdetektor nach einem der Ansprüche 3 bis 7,
**dadurch gekennzeichnet, daß**
nach Erfassung eines Impulssignals (P) die Erzeugung eines weiteren Impulsdetektorausgangssignals (STOP) so lange unterdrückt wird, bis das Impulssignal (P) ausreichend abgeklungen ist.

9. Impulsdetektor nach einem der Ansprüche 3 bis 8,
**dadurch gekennzeichnet, daß**
die Unterdrückung des Impulsdetektorausgangssignals (STOP) mittels eines Zeitzählers über eine vorgegebene Dauer geschieht.

10. Impulsdetektor nach einem der Ansprüche 3 bis 9,
**dadurch gekennzeichnet, daß**
ein dritter Komparator (33) vorgesehen ist, dessen einer Eingang mit dem elektrischen Impulssignal (P) gespeist wird, dessen anderer Eingang an einer einstellbaren dritten Referenzspannung (U_{Ref3}) liegt, die auf einen Wert nahe dem Amplitudenspitzenwert des Impulssignals (P) eingestellt ist und dessen Ausgang mit einem Eingang der Logikeinheit (35) verbunden ist, wobei die Logikeinheit (35) den Wert der zweiten Referenzspannung (U_{ref2}) dem Amplitudenspitzenwert bei schwankender Amplitude des Impulssignals (P) proportional nachführt (Schaltpunktnachführung).

11. Impulsdetektor nach Anspruch 10,
**dadurch gekennzeichnet, daß**
die zweite Referenzspannung (U_{Ref2}) über einen Spannungsteiler (12, 13) mit der dritten Referenzspannung (U_{Ref3}) verbunden ist.

12. Impulsdetektor nach Anspruch 11,
**dadurch gekennzeichnet, daß**
die erste Referenzspannung (U_{Ref1}) konstant bleibt.

13. Impulsdetektor nach einem der Ansprüche 10 bis 12,
**dadurch gekennzeichnet, daß**
die Logikeinheit (35) einen binären Wert an ihrem Ausgang bereitstellt, der mit Hilfe eines Digital-Analog-Wandlers (40) in einen Analogwert umgewandelt wird, um die zweite Referenzspannung (U_{Ref2}) der Amplitude der Impulssignale (P) proportional nachzuführen.

14. Impulsdetektor nach einem der vorhergehenden Ansprüche,
**dadurch gekennzeichnet, daß**
alle Referenzspannungen (U_{Ref1,} U_{Ref2,} U_{Ref3}) positiv sind.

15. Verfahren zur Detektion von sinusförmigen Impulsen durch Erfassung eines Schaltpunktes nahe dem Nulldurchgang eines Impulssignals, umfassend folgende Schritte
- Erfassen eines ersten Schaltpunktes, an dem das Impulssignal (P) einen nullpunktnahen ersten Schwellenwert (U_{Ref1}) übersteigt, und Erzeugen eines ersten Erfassungssignals (E1) bei Überschreiten des ersten Schwellenwerts (U_{Ref1}),
- Erfassen eines zweiten Schaltpunktes, an dem das Impulssignal (P) einen betragsmäßig größeren zweiten Schwellenwert (U_{Ref2}) übersteigt, und Erzeugen eines zweiten Erfassungssignals (E2) bei Überschreiten des zweiten Schwellenwerts (U_{Ref2}),
- Abtasten des ersten oder zweiten Erfassungssingals (E1, E2) mit einer vorgegebenen Tastfrequenz, und Erzeugen eines Aktivierungssignals (ENABLE), wenn wenigstens ein gültiger Abtastwert vorliegt, und
- Erzeugen eines Impulsdetektorausgangssignals (STOP), wenn das Impulssignal (P) den nullpunktnahen ersten Schwellenwert (U_{Ref1}) unterschreitet und gleichzeitig ein Aktivierungssignal (ENABLE) vorliegt.

16. Verfahren nach Anspruch 15,
**gekennzeichnet durch**
- Bereitstellen eines dritten Schwellenwertes (U_{Ref3}) nahe dem Amplitudenspitzenwert des Impulssignals (P),
- Feststellen, ob das durch den Erregerimpuls erzeugte Impulssignal (P) den dritten Schwellenwert (U_{Ref3}) übersteigt, und Erzeugen eines dritten Erfassungssignals (E3) bei Überschreiten des dritten Schwellenwerts (U_{Ref3}),
- Anheben bzw. Verringern des zweiten Schwellenwertes (U_{ref2}), falls die Amplitude des Impulssignals (P) größer bzw. kleiner ist als der dritte Schwellenwert (U_{Ref3}) (Schaltpunktnachführung).

17. Verfahren nach einem der Ansprüche 15 oder 16,
**gekennzeichnet durch**
- Zählen der dritten Erfassungssignale (E3) in einem vorgegebenen Meßintervall und Nachführen des zweiten Schwellenwertes (U_{Ref2}), wenn die Anzahl der Erfassungssignale (E3) einen vorgegebenen Sollwert übersteigt bzw. unterschreitet.

18. Impulsdetektor zur Detektion von sinusförmigen Impulsen durch Ermittlung der Symmetrielinie einer Halbwelle eines Impulssignals, umfassend
- einen Komparator (41), dessen einer Eingang mit dem elektrischen Impulssignal (P) gespeist wird, dessen anderer Eingang an einer vorgegebenen Referenzspannung (U_{Ref2}) liegt und dessen Ausgang mit einer Logikeinheit (35) verbunden ist,
**dadurch gekennzeichnet, daß**
- der Komparator (41) bei Überschreiten des Impulssignals (P) über die Referenzspannung (U_{ref2}) seinen Ausgang aktiviert und bei Unterschreiten der Referenzspannung (U_{Ref2}) seinen Ausgang deaktiviert,
- die Logikeinheit (35) die Aktivierung und Deaktivierung des Ausgangs auswertet und den Zeitpunkt der Symmetrielinie zwischen den beiden Ereignissen ermittelt.

19. Impulsdetektor nach Anspruch 18,
**dadurch gekennzeichnet, daß**
der Komparator (41) bei Überschreiten des Impulssignals (P) über die Referenzspannung (U_{ref2}) durch Aktivieren seines Ausgangs ein erstes Stopp-Zeitsignal (SZ1) erzeugt und ein zweiter Komparator (42) bei Unterschreiten der Referenzspannung (U_{Ref2}) ein zweites Stopp-Zeitsignal (SZ2) erzeugt.

20. Impulsdetektor nach einem der Ansprüche 18 oder 19,
**dadurch gekennzeichnet, daß**
die Auswertung der Stopp-Zeitsignale (SZ1, SZ2) durch einen hochauflösenden Zeitmeßschaltkreis erfolgt.

21. Impulsdetektor nach einem der Ansprüche 18 oder 19,
**dadurch gekennzeichnet, daß**
die Auswertung der Stopp-Zeitsignale (SZ1, SZ2) durch einen Integrator erfolgt.

22. Impulsdetektor nach Anspruch 21,
**dadurch gekennzeichnet, daß**
der Integrator bis zum Überschreiten des Impulssignals (P) über die Referenzspannung (U_{ref2}) mit einer vorgegebenen Integrationskonstante und nach diesem Ereignis mit der halben Integrationskonstante arbeitet.

23. Impulsdetektor nach einem der Ansprüche 18 bis 22,
**gekennzeichnet durch**
einen dritten Komparator (43), dessen einer Eingang mit dem elektrischen Impulssignal gespeist wird, dessen anderer Eingang an einer einstellbaren zweiten Referenzspannung (U_{Ref3}) liegt, die auf einen Wert nahe dem Amplitudenspitzenwert des Impulssignals (P) eingestellt ist, und dessen Ausgang mit einem Eingang der Logikeinheit (35) verbunden ist, wobei die Logikeinheit (35) mit den Referenzeingängen der Komparatoren (42, 43) derart rückgekoppelt ist, daß sie die erste Referenzspannung (U_{ref2}) anhebt bzw. verringert, falls die Amplitude des Impulssignals (P) größer bzw. kleiner ist als die zweite Referenzspannung (U_{Ref3}).

24. Verfahren zur Detektion von sinusförmigen Impulsen durch Ermittlung des Symmetriepunktes einer Halbwelle eines Impulssignals , umfassend folgende Schritte:
- Erfassen eines ersten Schaltpunktes, an dem das Impulssignal einen vorgegebenen Schwellenwert (U_{Ref2}) übersteigt und Aktivieren eines Komparatorausgangs,
- Erfassen eines zweiten Schaltpunktes, wenn das Impulssignal (P) den Schwellenwert (U_{Ref2}) wieder unterschreitet, und Deaktivieren des Komparatorausgangs, und
- Ermitteln des Symmetriepunktes zwischen den beiden Schaltereignissen.

25. Verfahren nach Anspruch 24,
**gekennzeichnet durch**
- Bereitstellen eines zweiten Schwellenwertes (U_{Ref3}) nahe dem Amplitudenspitzenwert des Impulssignals (P),
- Erfassen des Auslösezeitpunktes (START) eines von dem Impulsgenerator (5) ausgelösten Erregerimpulses,
- Feststellen, ob das von dem Erregerimpuls erzeugte Impulssignal (P) den zweiten Schwellenwert (U_{Ref2}) übersteigt, und Erzeugen eines Stopp-Zeitsignals (SZ3) bei Überschreiten des zweiten Schwellenwerts (U_{Ref3}),
- Anheben bzw. Verringern des ersten Schwellenwertes (U_{ref2}), falls die Amplitude des Impulssignals (P) größer bzw. kleiner ist als der zweite Schwellenwert (U_{Ref3}).

26. Magnetostriktiver Positionssensor mit einem Impulsgenerator, umfassend
- einen Spannungshochsteller (50) mit einem Speicherkondensator (C) zur Erzeugung einer Ausgangsspannung (U_{A}), die größer ist als die Eingangsspannung (U_{E}) des Hochstellers (50), und
- einen Erregerstromkreis (51) zur Erzeugung von kurzen magnetoelastischen Positionsimpulsen auf einem Wellenleiter,
**dadurch gekennzeichnet, daß**
der Impulsgenerator einen Schalter (19) aufweist, der bei Überschreiten der Ausgangsspannung (U_{A}) über einen vorgegebenen Grenzwert (G) so lange geschlossen wird, bis die Ausgangsspannung (U_{A}) wieder auf den Grenzwert abgesunken ist.

27. Magnetostriktiver Positionssensor nach Anspruch 26
**dadurch gekennzeichnet, daß**
die Überwachung der Ausgangsspannung (U_{A}) und das Schalten des Schalters (19) mit Hilfe einer Steuereinheit (45) erfolgt.

28. Magnetostriktiver Positionssensor mit
- einem Impulsgenerator, umfassend
- einen Spannungshochsteller (50) zur Erzeugung einer Ausgangsspannung (U_{A}), die größer ist als die Eingangsspannung (U_{E}) des Hochstellers (50),
- einen Erregerstromkreis (51) zur Erzeugung magnetoelastischer Impulssignale auf einem Wellenleiter, und
- einem Impulsdetektor (70) zur Detektion der magnetoelastischen Impulssignale des magnetostriktiven Positionssensors und Erzeugung eines dem magnetoelastischen Impulssignal entsprechenden elektrischen Impulssignals,
**dadurch gekennzeichnet, daß**
- das elektrische Impulssignal des Impulsdetektors (70) mittels wenigstens eines Komparators (31, 32, 33) ausgewertet wird, und
- ein Stromimpuls des Erregerkreises (51) und die Ausgangsspannung des Hochstellers (50) erfaßt und mittels Komparatoren (52, 53) mit vorgegebenen Referenzwerten verglichen werden, wobei die vorgegebenen Referenzwerte den Komparatoren (31, 32, 33, 52, 53) auf einer gemeinsamen Leitung (60) unter Überwachung durch eine Steuereinheit (45) zeitsequentiell zugeführt werden.
